(19) Europäisches Patentamt

European Patent Office

Office européen des brevets

(11) EP 0 619 650 B1

(12) **EUROPEAN PATENT SPECIFICATION**

(45) Date of publication and mention
of the grant of the patent:
**24.06.1998   Bulletin 1998/26**

(51) Int Cl.⁶: **H03K 5/13**

(21) Application number: **94200852.5**

(22) Date of filing: **29.03.1994**

(54) **Delay circuit for delaying differential signals**

Verzögerungsschaltung zum Verzögern von differentiellen Signalen

Circuit de rétard pour retarder des signaux différentiels

(84) Designated Contracting States:
**DE FR GB IT**

(30) Priority: **05.04.1993 EP 93200986**
**24.08.1993 EP 93202488**

(43) Date of publication of application:
**12.10.1994   Bulletin 1994/41**

(73) Proprietor: **Philips Electronics N.V.**
**5621 BA Eindhoven (NL)**

(72) Inventor: **Huizer, Cornelis Marinus**
**NL-5656 AA Eindhoven (NL)**

(74) Representative: **de Haas, Laurens Johan et al**
**INTERNATIONAAL OCTROOIBUREAU B.V.,**
**Prof. Holstlaan 6**
**5656 AA Eindhoven (NL)**

(56) References cited:
**EP-A- 0 493 149         EP-A- 0 523 854**
**US-A- 4 686 489         US-A- 4 876 519**

## Description

The invention relates to a delay circuit suitable for delaying of differential signals, comprising a first and a second switching transistor, each of which comprises a control electrode and a first and a second main electrode, a first and a second input of the delay circuit being coupled to the control electrode of the first switching transistor and the second switching transistor, respectively, the first main electrode of the first and the second switching transistor being coupled to one another and, *via* a first current source, to a first power supply terminal, the second main electrode of the first and the second switching transistor being coupled to a first and a second output, respectively, of the delay circuit, the first and second outputs being coupled to a second power supply terminal *via* respective first load circuits, respective first clamp circuits being coupled to the first and the second output in order to limit maximum attainable differences between a voltage on the second power supply terminal on the one side and a voltage on the respective outputs on the other side. The invention also relates to a cascade of such delay circuits.

A delay circuit of this kind is known from US pat. No. 4,876,519. The first and the second switching transistor control the connection between the current source and the load circuits. Depending on the difference between the voltages on the inputs, the current flows from the current source through the first or through the second switching transistor to the first or to the second output, respectively, and to the associated load circuit. Thus, the capacitance present on the output is alternately charged or discharged, depending on the difference.

For example, when the first switching transistor is turned on, the voltage on the first output decreases due to the discharging until the current source and the first switching transistor are saturated. The voltage on the second output increases until the associated load circuit is saturated.

When the input voltage changes so that the second switching transistor is turned on and the first switching transistor is turned off, the voltage on the second output decreases and the voltage on the first output increases. After a delay time on the outputs a voltage level is thus reached which suffices to switch over other circuits. The rise and fall speed, and hence the delay time, can be adjusted by means of the current through the current source.

However, the switching time is also dependent on the initial voltage at the instant of switching over of the input voltage. The clamp circuit provides the initial voltage for switching. The initial voltage, therefore, is not dependent on the parameters of the first and the second switching transistor or on the current source.

US pat. No. 4,876,519 does not teach how the circuit can be adapted to allow modification of the delay time by means of digital switching. The absolute delay time could be adjusted by adjusting the voltages $V_{bn}$ and $V_{bp}$, and hence the charging current I. However, it has been found that when it is attempted to realize different delay times in this manner, the parameters of the transistors have an effect on the ratio of the adjusted delay times.

European Patent Application No. 493 149 teaches modification of the delay time by digitally selecting additional load circuits to be switched in parallel to the load circuit. This publication does not disclose the use of a clamp circuit to define the initial voltage for switching.

It is *inter alia* an object of the invention to provide a delay circuit in which the ratio of the adjustable delay times is less dependent on the parameters of the transistors.

A delay circuit in accordance with the invention is characterized in that it comprises a second current source, second load circuits and second clamp circuits, as well as switching means for simultaneous connection of these components in parallel with the first current source, the respective first load circuits and the respective first clamp circuits, respectively, a dimension of each of the second current source (N52), second load circuits (P12, P22) and second clamp circuits (N32,N42) each having a respective ratio to a dimension of the corresponding the first current source (N51), first load circuits (P11, P21) and first clamp circuits (N31, N41), the respective ratios being equal to each other. The further circuits enable digital switching of the delay time between different values and ensure that the ratio of the switching times is accurately reproducible.

An embodiment of the delay circuit in accordance with the invention is characterized in that it is included in an integrated circuit in which each time a pair of respective, similar circuits is used for the first and the second current source, the first and the second load circuit and the first and the second clamp circuit, a ratio of the geometrical dimensions of the circuits of each pair being the same. All circuits directly relating to the delay time, as well as their inherent parasitic capacitances, are thus increased to the same scale upon switching on. Consequently, the ratio of the delay times with and without parallel-connected circuits is dependent notably on the ratio of the geometrical dimensions of the circuits. The ratio of the dimensions is accurately reproducible. Therefore, the ratio of the switching times is also suitably reproducible.

A further embodiment of the delay circuit in accordance with the invention is characterized in that it comprises a third and a fourth switching transistor which are connected, in as far as the control electrode and the second main electrode are concerned, parallel to the first and the second switching transistor, respectively, the first electrodes of the third and the fourth switching transistor being coupled to one another and, separately from the first electrodes of the first and the second switching transistor, to the first power supply terminal *via* the second current source. Due to the double construction of the switching transistors, the ratio of the switching times is also rendered independent of the process parameters when the input signals switch over only gradually.

A further embodiment of the delay circuit in accordance with the invention is characterized in that it comprises, between the first current source and the first output, a parallel connection of a first and a second series connection of main current channels of transistors, the first switching transistor forming part of the first series connection having control electrodes which are coupled to the first input and a first selection input, respectively, the second series connection having control electrodes which are coupled to a further first input and a second selection input, respectively, and in that it comprises a third and a fourth series connection of main current channels of transistors, connected in parallel between the second current source and the second output, the second switching transistor forming part of the third series connection which has control electrodes which are coupled to the second input and the first selection input, respectively, the fourth series connection comprising control electrodes which are coupled to a further second input and the second selection input, respectively. The delay circuit can thus multiplex between different input signals.

The use of delay circuits in accordance with the invention in a cascade is particularly attractive. Selective switching over of the delay times of a part of the delay circuits in a cascade of such circuits enables digital adjustment of the overall delay time of the cascade. In a cascade in accordance with the invention, comprising at least one delay circuit which also operates as a multiplexer, part of the cascade can be bypassed in a controlled manner. The adjustability of the delay time of the cascade is thus further improved.

A further embodiment of the cascade in accordance with the invention is characterized in that the outputs of one of the delay circuits, indirectly preceding the at least one delay circuit in the cascade, are connected to the further first and second input of the at least one delay circuit in the cascade. The cascade thus constitutes a ring oscillator. The number of stages thereof can be switched by means of the multiplexer. For the oscillation it is irrelevant whether or not the number of stages becomes even due to the switching of the multiplexer, because differential delay elements are used.

The invention will be described in detail hereinafter with reference to the accompanying drawing. Therein:

Fig. 1 shows an end-around coupled delay chain with symmetrical buffers.

Fig. 2 shows a symmetrical buffer.

Fig. 3 shows a buffer circuit in which the ratio of the adjustable delay times is less dependent on the parameters of the transistors.

Fig. 4 shows a further embodiment of the buffer circuit.

Fig. 5 shows a reference circuit for generating the reference voltages for the circuits shown in the Figs. 2, 3 and 4.

Fig. 6 shows a further ring oscillator.

Fig. 7 shows an embodiment of a buffer circuit which also serves as a multiplexer.

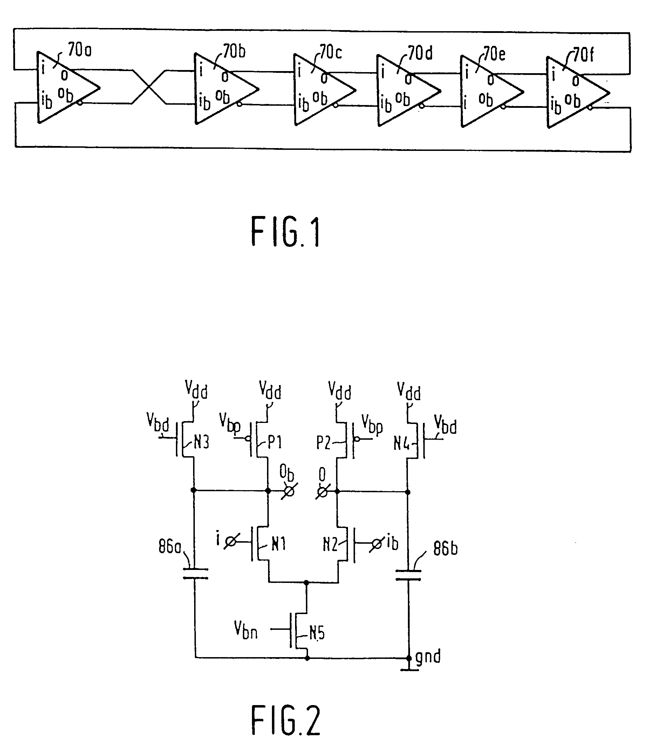

Fig. 1 shows a delay chain which is coupled end-around and which comprises symmetrical buffers 70a, b,c,d,e,f. Each buffer comprises a pair of inputs i, ib and a pair of outputs o, ob. In a full loop along the chain, the gain is negative (because the input and the output between two buffers 70a, 70b are cross-wise coupled: o to ib and i to ob). Because of the negative gain, the circuit will oscillate. The use of symmetrical buffers 70a,b,c,d, e,f offers the advantage that a negative loop gain can be obtained even with an even number of buffers 70a, b,c,d,e,f in the chain. The relationship between the phase of the signal in the chain and the phase of the oscillation is given by the following Table, in which each line represents a combination of logic states of the outputs "o" of successive buffers, in the left-hand column, whereas the right-hand column shows the associated phase in twelfth parts of 360 degrees.

| | |
|---|---|
| 000000 | 0 |
| 010000 | 1 |
| 011000 | 2 |
| 011100 | 3 |
| 011110 | 4 |
| 011111 | 5 |
| 111111 | 6 |
| 101111 | 7 |
| 100111 | 8 |
| 100011 | 9 |
| 100001 | 10 |
| 100000 | 11 |

For the sampling of the phase of the oscillator use can also be made of differential symmetrical circuits. This eliminates phase sampling errors which are dependent on the logic value of the sampled signal due to any asymmetry between delays for signals of different logic levels.

Fig. 2 shows a symmetrical buffer for use in the cascade of Fig. 1. It comprises an NMOS transistor N5 whose source is coupled to a first power supply (gnd). The drain of the NMOS transistor N5 is coupled, *via* two parallel branches, to a second power supply. Each branch comprises an NMOS switching transistor N1, N2 whose source is coupled to the drain of the NMOS transistor N5. The drains of the switching transistors N1, N2 are connected, *via* respective parallel connections of a PMOS load transistor P1, P2 with a clamp transistor N3, N4, to the second power supply $V_{dd}$. The gates of the switching transistors N1, N2 constitute the inputs i, ib of the buffer. The drains of the switching transistors N1, N2 constitute the outputs o, ob of the buffer. Between the outputs o, ob and the first power supply (gnd) capacitors 86a,b, are shown in Fig. 2. The switching transistors N1, N2 have the same dimensions; the same holds for the load transistors P1, P2.

During operation, the gate voltages $V_{bn}$ and $V_{bp}$ of the NMOS transistor N5 and the PMOS load transistors P1, P2 are controlled so that the current I through the PMOS transistors P1, P2 in the saturated condition amounts to half the current 2I through the NMOS transistor N5. The signal on the input i, ib switches the switching transistors N1, N2 from a position in which the current flows from the NMOS transistor N5 to one of the PMOS load transistors P1, P2 to a position in which this current flows to the other P1, P2. In the one position one of the capacitors, say 86a, is charged by a net current amounting to I, whereas the other capacitor 86b is discharged by a net current amounting to I.

Consequently, the amount of charge across the one capacitor 86a increases linearly in time. As a result, the voltage on the corresponding output ob also increases linearly in time. This continues until the increasing voltage brings the load transistor P1 out of the saturated state, after which the charging current decreases. The voltage on the other output "o" decreases linearly in time. This continues until the voltage "o" on this output decreases to the clamp voltage $V_{bd}$-$V_{th}$ at which the clamp transistor N4 is turned on. In the other position of the switching transistors N1, N2, the voltage on the output ob decreases linearly as a function of time until it reaches $V_{bd}$-$V_{th}$ (N3 is turned on when its source voltage is below its gate voltage $V_{bd}$ by an amount which exceeds a threshold voltage $V_{th}$). The voltage on the other output "o" increases linearly until the load transistor P2 is no longer saturated.

The switching time of the buffer is approximately equal to the period of time required to reverse the polarity of the difference between the voltages on the outputs o, ob. This time is proportional to the current I through the load transistors P1, P2.

The clamp transistors N3, N4 render the switching time independent of the saturation properties of the switching transistors N1, N2 and the NMOS transistor N5. This is achieved in that the clamp transistors N3, N4 determine the lowest voltages on the outputs o, ob, and hence the voltage difference to be overcome by the buffer by charging the capacitors 86a, 86b, before reversal of the polarity of the difference between the output voltages. This is attractive because the effect of temperature variations and a spread in the process parameters on the NMOS transistor N5 and the switching transistors N1, N2 thus has no effect on the switching time. A similar independence can be achieved by replacing the clamp transistors N2, N3, for example by diodes which also limit the minimum voltage to be reached. In that case this voltage is limited to the diode threshold voltage and cannot be adjusted.

The capacitors 86a,b can be explicitly provided, but in order to achieve an oscillator with an as high as possible frequency it suffices to utilize the parasitic capacitances always present in the circuit, so that no discrete capacitors need be provided.

It is one of the objects of the invention to realise the advantages of the digital technique in a phase loop. Attention is focused notably on the advantage that the functional behaviour of digital circuits is insensitive to a spread in the parameters of the circuit used. In the phase loop as described above, the ring oscillator constitutes the main component whose behaviour is still sensitive to parameter spreads. It is a problem notably that the ratio of the delay times realised with different settings of the buffer is sensitive to process parameters. When the oscillator is used in a digitally controlled phase locked loop. This ratio, together with the instantaneous oscillation frequency, is decisive in respect of loop gain, and hence in respect of dynamic behaviour of the phase locked loop which must be as reproducible as possible.

The absolute delay time can be adjusted by adjusting the voltages $V_{bn}$ and $V_{bp}$, and hence the charging current I. However, it has been found that when it is attempted to realise different delay times in this manner, the parameters of the transistors have an effect on the ratio of the adjusted delay times.

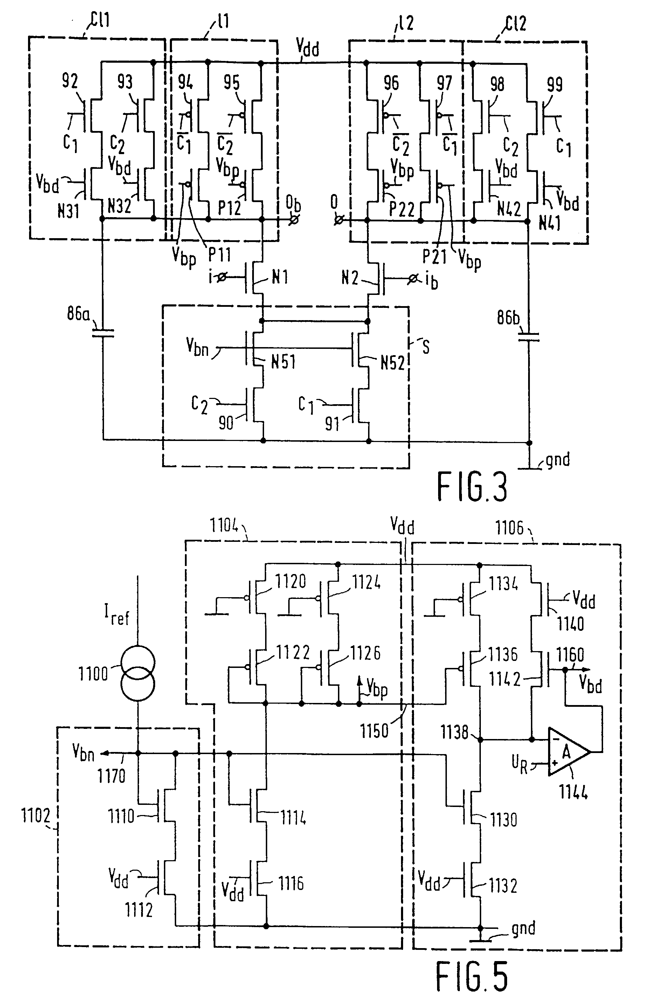

Fig. 3 shows a buffer circuit in which the ratio of the adjustable delay times is less dependent on the parameters of the transistors. The circuit is similar to that of Fig. 2, and elements having the same function therein are denoted by the same symbols. The difference consists in that the NMOS transistor N5 has been replaced by a tail current circuit S which comprises a parallel connection of two series connections, each of which includes the channel of a respective NMOS current source transistor N51, N52 and a current source switching transistor 90, 91. Furthermore, the drains of the switching transistors N1, N2 are connected to the second power supply $V_{dd}$ via switchable load and clamp circuits L1, L2, CL1, CL2.

Each of the load circuits L1, L2 comprises, connected in parallel, two series connections of a respective PMOS load switching transistor 94, 95, 96, 97 and a current-controlling PMOS transistor P11, P12, P21, P22. Each of the clamp circuits CL1, CL2 comprises, in parallel, two series connections of a respective NMOS clamp switching transistor 92, 93, 98, 99 and an NMOS clamp transistor N31, N32, N41, N42. For each circuit on the one output o there is provided a corresponding circuit on the other output ob, both circuits having substantially the same dimensions; because the dimensions are the same, the output signals are almost fully symmetrical.

During operation the NMOS current source transistors N51, N52 in the tail current circuit S have the same function as the NMOS transistor N5 in Fig. 2 (supplying a current 2I), be it that the current 2I, supplied under the control of the voltages $C_1$, $C_2$ on the respective gates of the current source switching transistors 90, 91, is switched between different values.

The current controlling PMOS transistors P11, P12, P21, P22 in the load circuits L1, L2 have the same function as the load transistors P1, P2 in Fig. 2 (supplying a current I), the difference existing in that under the control of the voltages $\overline{C}_1$, $\overline{C}_2$ (the logic inverse of $C_1$, $C_2$) on the respective gates of the load switching transistors 94, 95, 96, 97 the current I supplied can be switched between different values in conjunction with the switching of the current 2I by the tail current circuit S.

The NMOS clamp transistors N31, N32, N41, N42 in the clamp circuits CL1, CL2 have the same function as the clamp transistors N3, N4 in Fig. 2 (limiting the minimum voltage), be it that under the control of the voltages $C_1$, $C_2$ on the respective gates of the clamp switching transistors 92, 93, 98, 99 different clamp transistors N31, N32, N41, N42 are activated and deactivated.

For each circuit controlled by $C_1$ there is provided a functionally corresponding circuit which is controlled by $C_2$. The functionally corresponding circuits always have the same structure. Moreover, the ratio of the dimensions of the corresponding circuits is the same for all circuits: the ratio of the dimensions of the clamp circuit controlled by $C_1$ to those of the clamp circuit controlled by $C_2$ is equal to the ratio of the dimensions of the load circuit controlled by $C_1$ to those of the load circuit controlled by $C_2$; the same holds for the tail current circuits. Furthermore, the ratio of all kinds of parasitic effects will also be approximately the same. This ensures that the ratio of the adjusted delay times is reasonably independent of the parameters of the transistors.

Because the clamps CL1, CL2 can also be switched and are switched together with the loads and the tail current source, the ratio of the currents for the various logic values of the voltages $C_1$ and $C_2$ is independent of the parameters of the transistors, so that the buffer is very suitable for use as a switchable delay element in a digitally controlled phase loop.

In Fig. 3 two switching voltages $C_1$ and $C_2$ are used by way of example, but evidently additional independent switching voltages ($C_3$ etc.) can also be used. If only two switching positions are required, one voltage suffices and the other voltage, for example $C_2$, can be permanently connected to the positive power supply $V_{dd}$ (and its inverse $\overline{C}_2$ to the negative power supply (gnd)).

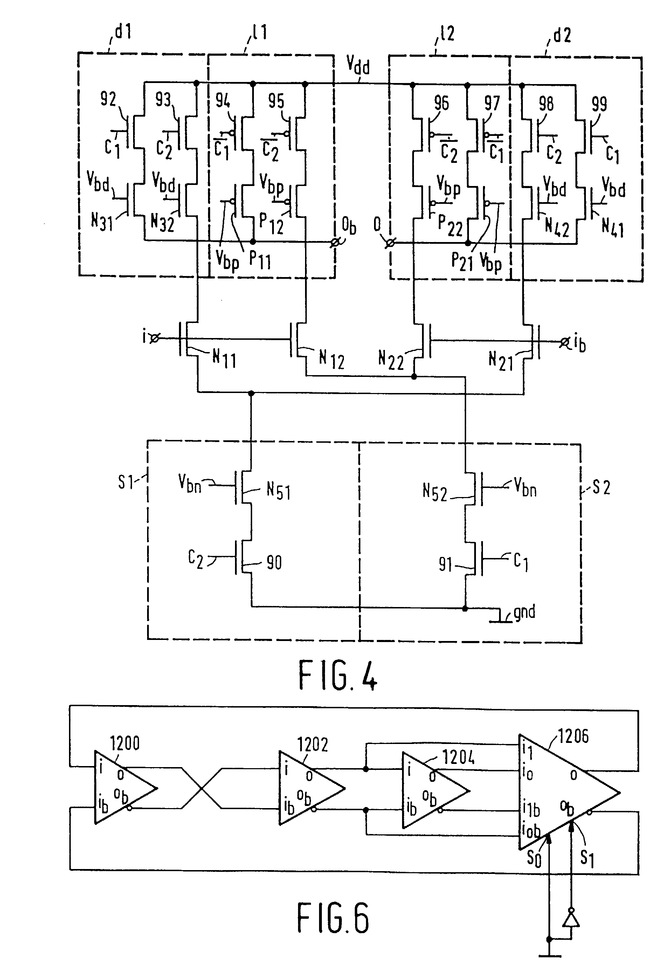

Fig. 4 shows a further embodiment of the buffer. This embodiment corresponds to that shown in Fig. 3, except that the switching transistors N1, N2 have also been doubled so as to form two pairs N11, N21 and N12, N22, in each pair the sources being connected to one another and to a respective tail current source S1, S2. The sources of the different transistor pairs N11, N21 and N12, N22 and of the tail current sources S1, S2 are not connected to one another. The other elements of Fig. 4 have the same function as those shown in Fig. 3 and are denoted by the same symbols.

During operation the ratio of the currents occurring for the various values of the switching voltages $C_1$, $C_2$ is even less sensitive to variations in the parameters of the transistors. This can be attributed *inter alia* to the following. The difference between the voltages on the inputs i, ib normally increases linearly in time. As a result, there will be a time interval during which both switching transistors N1, N2 in the Figs. 2 and 3 are turned on. The distribution of the current between these transistors is dependent on the parameters of these transistors, notably on their steepness. Because the switching transistors N1, N2 must switch different currents for different values of $C_1$ and $C_2$, the steepness influences the ratio of the switching times. In the circuit shown in Fig. 4, the switching transistors N11, N21 and N12, N22 are also effectively switched on and off by the signals $C_1$ and $C_2$, respectively. As a result, variations in the steepness of the switching transistors N11, N12, N21, N22 are irrelevant to the ratio of the delay times. This results in even better reproducibility of digital control circuits utilizing the buffer as a switchable delay element.

Fig. 5 shows a reference circuit for generating the reference voltages $V_{bd}$, $V_{bn}$, $V_{bp}$ for the circuits shown in the Figs. 2, 3 and 4. The reference circuit is a mirror-image of the buffer as shown, for example in Fig. 3. For each component of Fig. 3, with the exception of the switching transistors N1, N2, there is provided a corresponding circuit whereby an associated reference voltage is generated during operation. The reference circuit comprises sub-circuits 1102, 1104, 1106 for generating the voltages $V_{bn}$, $V_{bp}$ and $V_{bd}$ for the tail current circuits S, S1, S2, the load circuits L1, L2 and the clamp circuits CL1, CL2, respectively.

The sub-circuit 1102 for generating $V_{bn}$ comprises a series connection of the channels of two NMOS transistors 1110, 1112 between a current source 1100 and the first power supply (gnd). These two transistors 1110, 1112 correspond to the tail current circuit S of Fig. 3. The gate of one of the transistors, 1110, is connected to its drain, the voltage $V_{bn}$ being tapped from this gate. The gate of the other transistor, 1112, is coupled to the second power supply $V_{dd}$. During operation the sub-circuit 1102 mirrors the reference current $I_{ref}$ to the tail current circuit S of the buffer by the coupling of $V_{bn}$.

The sub-circuit 1104 for generating $V_{bp}$ comprises two NMOS transistors 1114, 1116 which correspond to the transistors in the load circuits L1, L2. The two NMOS transistors 1114, 1116 are coupled to the transistors 1110, 1112 so that they form, in conjunction with the transistors 1110, 1112 of the sub-circuit 1102, a current mirror for mirroring the reference current $I_{ref}$. The output of this current mirror is connected, *via* a parallel connection of two series connections of the channels of PMOS transistors 1120, 1122, 1124, 1126, to the second power supply $V_{dd}$. The gate of one PMOS transistor 1122, 1126 in each series connection is connected to its drain. The voltage $V_{bn}$ is tapped from the drains of the transistors 1122, 1126. The gate of the other PMOS transistor 1120, 1124 is connected to ground. When transistors are used, the sub-circuit 1104 mirrors half the reference current to the load circuits L1, L2 *via* the coupling of $V_{bp}$.

The sub-circuit 1106 for generating $V_{bd}$ comprises two PMOS transistors 1134, 1136 which are coupled to the PMOS transistors 1120, 1122 so that they form a current mirror in conjunction with the transistors 1120, 1122 of the sub-circuit 1104. The output of this current mirror is connected to the first power supply *via* a series connection of the channels of two NMOS transistors 1130, 1132. The gate of one of these transistors, 1130, is coupled to $V_{bn}$, the gate of the other transistor, 1132, being connected to the second power supply $V_{dd}$. In parallel with the two PMOS transistors 1134, 1136 there is connected a series connection of the channels of two further NMOS transistors. These further transistors correspond to the transistors of the clamp circuits CL1, CL2. The junction 1138 of the PMOS transistors 1136, 1134 and the NMOS transistors 1130, 1132 is coupled to the inverting input of a control amplifier 1144. The output of this control amplifier is coupled to the gate of one of the further NMOS transistors 1160. The gate of the other further NMOS transistor is coupled to the second power supply $V_{dd}$. The non-inverting input of the control amplifier 1144 is connected to a reference voltage $U_R$. The control amplifier 1144 readjusts $V_{bd}$ so that the clamp voltage for the given currents equals $U_R$. It has been found that $U_R = V_{dd}/2$ offers suitable results, but if the dependency on possible fluctuations in the supply voltage is undesirable, use can also be made of a reference voltage source, for example a bandgap reference.

Fig. 6 shows a further ring oscillator. This oscillator comprises, by way of example, four symmetrical buffer circuits 1200, 1202, 1204, 1206 which are connected in series. Only the first and the second symmetrical buffer circuits, 1200, 1202 are cross-wise coupled. As a result, the circular gain is negative. The outputs of the second buffer circuit, 1202, as well as of the third buffer circuit, 1204, are coupled to respective inputs of the fourth buffer circuit, 1206. The fourth buffer circuit, 1206, also constitutes a multiplexer and comprises control inputs S0, S1 which receive logically opposed signals. This controls which of the input signals is applied to the outputs.

During operation, the number of buffer circuits in the ring oscillator, and hence the oscillation frequency, can be controlled by way of the control inputs S0, S1. This is a further mechanism which can be used for digital control of the frequency of a ring oscillator.

Only one of the buffer circuits in Fig. 6 is a multiplexer. It is alternatively possible to include several multiplexers in the ring oscillator, so that a larger or smaller part of the buffer circuits in the ring oscillator can be skipped in a controlled manner so as to achieve digital control of the oscillation frequency.

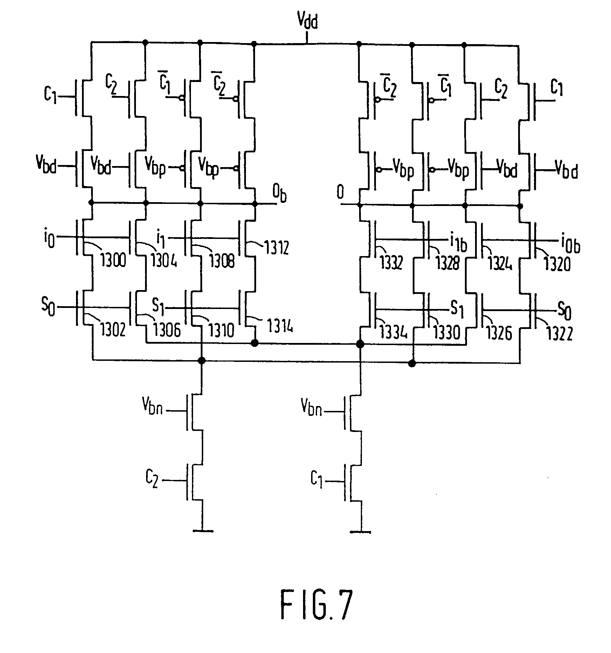

Fig. 7 shows an embodiment of the buffer circuit which also serves as a multiplexer. The majority of the components correspond to the components of Fig. 4 and are not elaborated. The difference with respect to Fig. 4 consists in that the switching transistors N11, N12, N21, N22 of Fig. 4 have been replaced in Fig. 7 by a respective parallel connection of two series connections of the channels of two transistors (N11 replaced by 1300, 1302 in series, and 1308, 1310 in series; N12 by 1304, 1306 in series and 1312, 1314 in series; N21 by 1320, 1322 in series and 1330, 1328 in series; N22 by 1324, 1326 in series and 1332, 1334 in series).

During operation, each time one of every two parallel-connected series connections is activated by means of S0, S1. One of the input signals i1, i0 corresponds to each S0, S1. Consequently, always only one of the input signals i1, i0 is active. The active input signal determines, in the manner described with reference to the Figs. 2, 3 and 4, the load circuit whereto the current flows. The signals on S0, S1 determine which of the input signals il, i0 is applied to the output o, ob in this manner.

## Claims

1. A delay circuit suitable for delaying of differential signals, comprising a first and a second switching transistor (N1,N2,N11,N21), each of which comprises a control electrode and a first and a second main electrode, a first and a second input ($i,i_b$) of the delay circuit being coupled to the control electrode of the first switching transistor (N1) and the second switching transistor (N2,N11,N21), respectively, the first main electrode of the first and the second switching transistor (N1,N2,N11,N21) being coupled to one another and, *via* a first current source (N51), to a first power supply terminal (gnd), the second main electrode of the first and the second switching transistor (N1,N2,N11,N21) being coupled to a first and a second output (O, Ob), respectively, of the delay circuit, the first and second outputs ($O,O_b$) being coupled to a second power supply terminal (Vdd) *via* respective first load circuits (P11,P21), respective first clamp circuits (N31,N41) being coupled to the first and the second output (O, $O_b$) in order to limit maximum attainable differences between a voltage on the second power supply terminal (Vdd) on the one side and a voltage on the respective outputs (O,Ob) on the other side, characterized in that it comprises a second current source (N52), second load circuits (P12,P22) and second clamp circuits (N32,N42), as well as switching means (93,95,96,98) for simultaneous connection of these components (N52,P12,P22,N32,N42) in parallel with the first current source (N51), the respective first load circuits (P11,P21), and the respective first clamp circuits (N31,N41), respectively, a dimension of each of the second current source (N52), second load circuits (P12, P22) and second clamp circuits (N32.N42) each having a respective ratio to a dimension of the corresponding the first current source (N51), first load circuits (P11, P21) and first clamp circuits (N31, N41), the respective ratios being equal to each other.

2. A delay circuit as claimed in Claim 1, characterized in that it is included in an integrated circuit in which a pair of respective, similar circuits is used for the first and the second current source (N51,N52), the first and the second load circuit (P11,P21,P12,P22), and the first and the second clamp circuit (N31,N41,N32,N42), a ratio of the geometrical dimensions of the circuits of each pair being the same.

3. A delay circuit as claimed in Claim 1 or 2, characterized in that it comprises a third and a fourth switching transistor (N12,N22) which are connected in as far as the control electrode and the second main electrode are concerned, parallel to the first and the second switching transistor (N11,N21), respectively, the first electrodes of the third and the fourth switching transistor (N12,N22) being coupled to one another and, separately from the first electrodes of the first and the second switching transistor (N11,N21), to the first power supply terminal (gnd) *via* the second current source (N52).

4. A delay circuit as claimed in Claim 1, 2, or 3, characterized in that

   - it comprises, between the first current source and the first output (O), a parallel connection of a first and a second series connection (1332, 1334, 1324, 1326) of main current channels of transistors, the first switching transistor (1332) forming part of the first series connection (1332, 1334) having control electrodes which are coupled to the first input (i1b) and a first selection input (S1), respectively, the second series connection (1324,1326) having control electrodes which are coupled to a further first input (i0b) and a second selection input (S0), respectively, and in that it comprises a third and a fourth series connection (1300,1302, 1308,1310) of main current channels of transistors, connected in parallel between the second current source and the second output (Ob), the second switching transistor (1308) forming part of the third series connection (1308,1310) with control electrodes which are coupled to the second input (I1) and the first selection input (S1), respectively, the fourth series connection (1300,1302) comprising control electrodes which are coupled to a further second input (i0) and the second selection input (S0), respectively.

5. A delay circuit as claimed in any one of the Claims 1 to 4, characterized in that the respective first load circuits (P11,P21) are constructed as current controllers which are adapted to draw substantially half the amount of current supplied by the first current source (N51).

6. A delay circuit as claimed in any one of the Claims 1 to 5, characterized in that the respective clamp circuits (N31,N41) comprise clamp transistors which are coupled to the relevant output (O,Ob) by way of a first main electrode and the control electrode of which receives a reference voltage.

7. A cascade of delay circuits (70a-f, 1200, 1202, 1204, 1206) as claimed in any one of the Claims 1 to 6.

8. A cascade (1200,1202,1204,1206) as claimed in Claim 7, comprising at least one delay circuit (1206) as claimed in Claim 4, characterized in that the outputs of one of the delay circuits (1202), indirectly preceding the at least one delay circuit (1206) in the cascade (1200,1202,1204,1206), are connected to the further first and second input (i1,i0b) of the at least one delay circuit (1206) in the cascade.

9. A cascade (70a-f, 1200, 1202, 1204, 1206) as claimed in Claim 7 or 8, characterized in that the outputs of a last delay circuit in the cascade are retrocoupled to the inputs of a first delay circuit so that the circular gain is negative.

**Patentansprüche**

1. Verzögerungsschaltung, die zum Verzögern von differentiellen Signalen geeignet ist, mit einem ersten und einem zweiten Schalttransistor (N1, N2, N11, N21), von denen jeder eine Steuerelektrode und eine erste und eine zweite Hauptelektrode umfaßt, wobei ein erster und ein zweiter Eingang (i, $i_b$) der Verzögerungsschaltung mit der Steuerelektrode des ersten Schalttransistors (N1) bzw. des zweiten Schalttransistors (N2, N11, N21) gekoppelt ist, wobei die erste Hauptelektrode des ersten und des zweiten Schalttransistors (N1, N2, N11, N21) miteinander gekoppelt sind und, über eine erste Stromquelle (N51), mit einem ersten Stromversorgungsanschluß (gnd), wobei die zweite Hauptelektrode des ersten und des zweiten Schalttransistors (N1, N2, N11, N21) mit einem ersten bzw. einem zweiten Ausgang (O, $O_b$) der Verzögerungsschaltung gekoppelt sind, wobei der erste und der zweite Ausgang (O, $O_b$) über jeweilige erste Lastschaltungen (P11, P12) mit einem zweiten Stromversorgungsanschluß (Vdd) gekoppelt sind, wobei jeweilige erste Klemmschaltungen (N31, N41) mit dem ersten und dem zweiten Ausgang (O, $O_b$) gekoppelt sind, um maximal erreichbare Differenzen zwischen einer Spannung am zweiten Stromversorgungsanschluß (Vdd) einerseits und einer Spannung an den jeweiligen Ausgängen (O, O$_b$) andererseits zu begrenzen, dadurch gekennzeichnet, daß sie eine zweite Stromquelle (N52) umfaßt, zweite Lastschaltungen (P12, P22) und zweite Klemmschaltungen (N32, N42) sowie Schaltmittel (93, 95, 96, 98), um diese Komponenten (N52, P12, P22, N32, N42) mit der ersten Stromquelle (N51), den jeweiligen ersten Lastschaltungen (P11, P21) bzw. den ersten Klemmschaltungen (N31, N41) gleichzeitig parallel zu schalten, wobei eine Abmessung der zweiten Stromquelle (N52), der zweiten Lastschaltungen (P12, P22) und zweiten Klemmschaltungen (N32, N42) jeweils ein jeweiliges Verhältnis zur Abmessung der entsprechenden ersten Stromquelle (N51), ersten Lastschaltungen (P11, P21) und ersten Klemmschaltungen (N31, N41) hat und diese jeweiligen Verhältnisse zueinander gleich sind.

2. Verzögerungsschaltung nach Anspruch 1, dadurch gekennzeichnet, daß sie in einer integrierten Schaltung enthalten ist, in der ein Paar jeweiliger gleichartiger Schaltungen für die erste und die zweite Stromquelle (N51, N52), die erste und die zweite Lastschaltung (P11, P21, P12, P22) und die erste und die zweite Klemmschaltung (N31, N41, N32, N42) verwendet wird, wobei ein Verhältnis der geometrischen Abmessungen der Schaltungen jedes Paares das gleiche ist.

3. Verzögerungsschaltung nach Anspruch 1 oder 2, dadurch gekennzeichnet, daß sie einen dritten und einen vierten Schalttransistor (N12, N22) umfaßt, die, was die Steuerelektrode und die zweite Hauptelektrode betrifft, parallel zum ersten bzw. zweiten Schalttransistor (N11, N21) geschaltet sind, wobei die ersten Elektroden des dritten und des vierten Schalttransistors (N12, N22) miteinander und, getrennt von den ersten Elektroden des ersten und des zweiten Schalttransistors (N11, N21), über die zweite Stromquelle (N52) mit dem ersten Stromversorgungsanschluß (gnd) gekoppelt sind.

4. Verzögerungsschaltung nach Anspruch 1, 2 oder 3, dadurch gekennzeichnet, daß

- sie zwischen der ersten Stromquelle und dem ersten Ausgang (O) eine Parallelschaltung aus einer ersten und einer zweiten Reihenschaltung (1332, 1334, 1324, 1326) von Hauptstromkanälen von Transistoren umfaßt, wobei der erste Schalttransistor (1332) Teil der ersten Reihenschaltung (1332, 1334) ist, die Steuerelektroden hat, die mit dem ersten Eingang (ilb) bzw. einem ersten Selektionseingang (S1) gekoppelt sind, wobei die zweite Reihenschaltung (1324, 1326) Steuerelektroden hat, die mit einem weiteren ersten Eingang (i0b) bzw. einem zweiten Selektionseingang (S0) gekoppelt sind, und daß sie eine dritte und eine vierte Reihenschaltung (1300, 1302, 1308, 1310) von Hauptstromkanälen von Transistoren umfaßt, die parallel zwischen die zweite Stromquelle und den zweiten Ausgang (Ob) geschaltet sind, wobei der zweite Schalttransistor (1308) Teil der dritten Reihenschaltung (1308, 1310) mit Steuerelektroden ist, die mit dem zweiten Eingang (I1) bzw. dem ersten Selektionseingang (S1) gekoppelt sind, wobei die vierte Reihenschaltung (1300, 1302) Steuerelektroden umfaßt, die mit einem weiteren zweiten Eingang (i0) bzw. dem zweiten Selektionseingang (S0) gekoppelt sind.

5. Verzögerungsschaltung nach einem der Ansprüche 1 bis 4, dadurch gekennzeichnet, daß die jeweiligen ersten Lastschaltungen (P11, P21) als Stromregler ausgeführt sind, die angepaßt sind, um nahezu die halbe von der ersten Stromquelle (N51) gelieferte Menge Strom zu ziehen.

6. Verzögerungsschaltung nach einem der Ansprüche 1 bis 5, dadurch gekennzeichnet, daß die jeweiligen Klemmschaltungen (N31, N41) Klemmtransistoren umfassen, die über eine erste Hauptelektrode mit dem betreffenden Ausgang (O, Ob) gekoppelt sind und deren Steuerelektrode eine Bezugsspannung empfängt.

7. Kaskade aus Verzögerungsschaltungen (70a-f, 1200, 1202, 1204, 1206) nach einem der Ansprüche 1 bis 6.

8. Kaskade (1200, 1202, 1204, 1206) nach Anspruch 7, mit zumindest einer Verzögerungsschaltung (1206) nach Anspruch 4, dadurch gekennzeichnet, daß die Ausgänge einer der Verzögerungsschaltungen (1202), die indirekt der zumindest einen Verzögerungsschaltung (1206) in der Kaskade (1200, 1202, 1204, 1206) vorangehen, mit dem weiteren ersten und zweiten Eingang (il, i0b) der zumindest einen Verzögerungsschaltung (1206) in der Kaskade verbunden sind.

9. Kaskade (70a-f, 1200, 1202, 1204, 1206) nach Anspruch 7 oder 8, dadurch gekennzeichnet, daß die Ausgänge einer letzten Verzögerungsschaltung in der Kaskade zu den Eingängen einer ersten Verzögerungsschaltung zurückgekoppelt sind, so daß die Kreisverstärkung negativ ist.

**Revendications**

1. Circuit à retard approprié pour retarder des signaux différentiels, comprenant un premier et un deuxième transistors de commutation (N1, N2, N11, N21), qui comprennent chacun une électrode de commande et une première et une deuxième électrodes principales, une première et une deuxième entrées (i, $i_b$) du circuit à retard étant respectivement reliées à l'électrode de commande du premier transistor de commutation (N1) et à l'électrode de commande du deuxième transistor de commutation (N2, N11, N21), les premières électrodes principales des premier et deuxième transistors de commutation (N1, N2, N11, N21) étant reliées l'une à l'autre et, via une première source de courant (N51), à une première borne de source d'alimentation (gnd), les deuxièmes électrodes principales des premier et deuxième transistors de commutation (N1, N2, N11, N21) étant respectivement reliées à une première et à une deuxième sorties (O, $O_b$) du circuit à retard, les première et deuxième sorties (O, $O_b$) étant respectivement reliées à une deuxième borne de source d'alimentation ($V_{dd}$) via des premiers circuits de charge (P11, P21) respectifs, des premiers circuits de verrouillage (N31, N41) respectifs étant reliés à la première et à la deuxième sorties (O, $O_b$) afin de limiter les différences maximales pouvant être obtenues entre une tension à la deuxième borne de source d'alimentation ($V_{dd}$) d'un côté et une tension aux sorties (O, $O_b$) respectives de l'autre côté, caractérisé en ce qu'il comprend une deuxième source de courant (N52), des deuxièmes circuits de charge (P12, P22) et des deuxièmes circuits de verrouillage (N32, N42) ainsi que des moyens de commutation (93, 95, 96, 98) pour une connexion simultanée desdits composants (N52, P12, P22, N32, N42) en parallèle respectivement avec la première source de courant (N51), les premiers circuits de charge respectifs (P11, P21) et les premiers circuits de verrouillage respectifs (N31, N41), une dimension de chacune de la deuxième source de courant (N52), des deuxièmes circuits de charge (P12, P22) et des deuxièmes circuits de verrouillage (N32, N42) ayant chacune un rapport respectif à l'égard d'une dimension des éléments correspondants que sont la première source de courant (N51), les premiers circuits de charge (P11, P21) et les premiers circuits de verrouillage (N31, N41), les rapports respectifs étant égaux entre eux.

2. Circuit à retard suivant la revendication 1, caractérisé en ce qu'il est inclus dans un circuit intégré dans lequel une paire de circuits respectifs similaires est utilisée pour la première et la deuxième sources de courant (N51, N52), le premier et deuxième circuits de charge (P11, P21, P12, P22) et le premier et deuxième circuits de verrouillage (N31, N41, N32, N42), un rapport des dimensions géométriques des circuits de chaque paire étant le même.

3. Circuit à retard suivant la revendication 1 ou 2, caractérisé en ce qu'il comprend un troisième et un quatrième transistors de commutation (N12, N22) qui sont reliés, en ce qui concerne l'électrode de commande et la deuxième électrode principale, en parallèle respectivement avec le premier et le deuxième transistors de commutation (N11, N21), les premières électrodes du troisième et du quatrième transistors de commutation (N12, N22) étant reliées entre elles et, séparément des premières électrodes du premier et du deuxième transistors de commutation (N11, N21), à la première borne de source d'alimentation (gnd) via la deuxième source de courant (N52).

4. Circuit à retard suivant la revendication 1, 2 ou 3, caractérisé en ce qu'il comprend, entre la première source de courant et la première sortie (O), une liaison parallèle d'un premier et d'un deuxième montage en série (1332, 1334, 1324, 1326) des principaux canaux de courant des transistors, le premier transistor de commutation (1332) faisant partie du premier montage en série (1332, 1334) comportant des électrodes de commande qui sont reliées respectivement à la première entrée ($i_{1b}$) et à une première entrée de sélection (S1), le deuxième montage en série (1324, 1326) comportant des électrodes de commande qui sont reliées respectivement à une autre premier entrée ($i_{0b}$) et à une deuxième entrée de sélection ($S_0$), et en ce qu'il comprend un troisième et un quatrième montages en série (1300, 1302, 1308, 1310) des canaux de courant principaux des transistors, reliés en parallèle entre la deuxième source de courant et la deuxième sortie ($O_b$), le deuxième transistor de commutation (1308) faisant partie du troisième montage en série (1308, 1310) qui comporte des électrodes de commande qui sont reliées respectivement à la deuxième entrée ($I_1$) et à la première entrée de sélection ($S_1$), le quatrième montage en série (1300, 1302) comprenant des électrodes de commande qui sont reliées respectivement à une autre deuxième entrée ($i_0$) et à la deuxième entrée de sélection ($S_0$).

5. Circuit à retard suivant l'une quelconque des revendications 1 à 4, caractérisé en ce que les premiers circuits de charge (P11, P21) respectifs sont construits comme des contrôleurs de courant qui sont à même de soustraire pratiquement la moitié de la quantité de courant fournie par la première source de courant (N51).

6. Circuit à retard suivant l'une quelconque des revendications 1 à 5, caractérisé en ce que les circuits de verrouillage (N31, N41) respectifs comprennent des transistors de verrouillage qui sont reliés à la sortie correspondante (O, $O_b$) par l'intermédiaire d'une première électrode principale et l'électrode de commande du transistor de verrouillage recevant une tension de référence.

7. Cascade de circuits à retard (70a-f, 1200, 1202, 1204, 1206) suivant l'une quelconque des revendications 1 à 6.

8. Cascade de circuits à retard (1200, 1202, 1204, 1206) suivant la revendication 7, comprenant au moins un circuit à retard (1206) suivant la revendication 4, caractérisée en ce que les sorties de l'un des circuits à retard (1202), situé en amont dudit au moins un circuit à retard (1206) de la cascade (1200, 1202, 1204, 1206), sont reliées à une autre première et deuxième entrées ($i_1$, $i_{0b}$) dudit au moins un circuit à retard (1206) de la cascade.

9. Cascade de circuits à retard (70a-f, 1200, 1202, 1204, 1206) suivant la revendication 7 ou 8, caractérisée en ce que les sorties d'un dernier circuit à retard dans la cascade sont reliées en boucle aux entrées d'un premier circuit à retard afin d'obtenir un gain circulaire négatif.

FIG.1

FIG.2

11

FIG.3

FIG.5

FIG. 4

FIG. 6

FIG. 7